# EUROPÄISCHE PATENTSCHRIFT

(11) **EP 2 891 527 B1**
(45) Veröffentlichungstag und Bekanntmachung des Hinweises auf die Patenterteilung: **04.05.2016**
(21) Anmeldenummer: 14150184.1
(22) Anmeldetag: 06.01.2014
(51) Int. Cl.: B21D 5/04, B29C 53/04

(54) **BIEGEVORRICHTUNG FÜR SEMIFLEX-LEITERPLATTEN**
BENDING DEVICE FOR SEMIFLEX CIRCUIT BOARDS
DISPOSITIF DE PLIAGE POUR CIRCUITS IMPRIMÉS SEMIFLEX

(43) Veröffentlichungstag der Anmeldung: 08.07.2015
(73) Patentinhaber: dSPACE digital signal processing and control engineering GmbH, 33102 Paderborn (DE)
(72) Erfinder: Breicher, Robert, 33106 Paderborn (DE)

(56) Entgegenhaltungen:
- DE-A1- 1 816 504
- GB-A- 1 399 873
- US-A1- 2004 178 539

## Beschreibung

Die Erfindung betrifft eine Biegevorrichtung zum Biegen einer Semiflex-Leiterplatte, die mindestens einen Flexbereich aufweist, an den an zwei gegenüberliegenden Seiten je ein Starrbereich anschließt, mit zwei Flügeln und einer auf dem ersten Flügel angebrachten ersten Fixiervorrichtung zur Fixierung eines ersten Starrbereichs der Leiterplatte und einer auf dem zweiten Flügel angebrachten zweiten Fixiervorrichtung zur Fixierung eines zweiten Starrbereichs der Leiterplatte, wobei wenigstens einer der beiden Flügel um eine Schwenkachse verschwenkbar ist.

Die Erfindung betrifft auch ein Verfahren zum Biegen einer Semiflex-Leiterplatte mit mindestens einem beidseitig an je einen Starrbereich anschließenden Flexbereich mit einer Biegevorrichtung, insbesondere der vorgenannten Art, wobei ein erster Starrbereich in einer ersten Fixiervorrichtung eines ersten Flügels der Biegevorrichtung fixiert wird und ein benachbart angeordneter, vom ersten Starrbereich durch einen Flexbereich beabstandeter zweiter Starrbereich in einer zweiten Fixiervorrichtung eines zweiten Flügels der Biegevorrichtung fixiert wird und der Flexbereich durch Verschwenkung wenigstens eines der Flügel gegen den anderen Flügel um eine Schwenkachse gebogen wird.

Eine Leiterplatte oder Platine besteht üblicherweise aus einer flachen Platte oder Scheibe aus Epoxidharz, die als Trägersubstrat für eine Vielzahl elektronischer Komponenten dient. Leiterplatten finden seit langer Zeit in Computersystemen vielfache Verwendung. In das Epoxid-Trägersubstrat eingelassen sind Kupferleitungen, insbesondere angeordnet in mehreren Schichten. Sie dienen der Verbindung der elektronischen Komponenten untereinander sowie mit Daten- und Stromanschlüssen, über die die Leiterplatte mit dem Computersystem, in dem sie eingesetzt wird, verbindbar ist. Leiterplatten können fest verbaute Komponenten eines Computersystems sein oder als auswechselbare Module in Form steckbarer Leiterplatten die Funktionalität des Systems erweitern, beispielsweise als Graphikkarten, Modems oder Messkarten.

In vielen Systemen werden gebogene Leiterplatten eingesetzt, vor allem, um durch Faltung großer Leiterplatten eine bessere Raumausnutzung zu erreichen. Ein solcher Biegevorgang stellt aber für das Trägersubstrat und die darin verlegten Kupferleitungen eine große mechanische Beanspruchung dar, für die sie eigentlich nicht ausgelegt ist. Die Biegung einer Leiterplatte um 90° oder sogar 180° ohne entsprechende Vorbereitung würde unweigerlich zum Bruch der Platte führen.

Der Stand der Technik kennt unterschiedliche Lösungen dieses Problems. Vollflex-Leiterplatten bestehen statt aus Epoxid aus flexiblem Material und werden vor allem in sehr kompakten Systemen wie Mobiltelefonen eingesetzt. Starrflex-Leiterplatten bestehen aus mehreren starren Einzelleiterplatten, die durch Kabel untrennbar miteinander verbunden sind. Eine dritte Variante sind Semiflex-Leiterplatten. Bei dieser Lösung wird der für die Biegung vorgesehene Bereich der Leiterplatte so stark verdünnt, z.B. so tief zumindest von einer Seite ausgefräst, bis nur noch eine dünne Epoxid-Schicht mit bevorzugt einer einzigen Lage von Kupferleitungen übrig ist, die die vorgesehene Biegung ohne Materialschäden überstehen kann.

Diese Lösung ist die konstengünstigste, unterliegt dafür aber starken Einschränkungen. Da der verdünnte Bereich (im folgenden Flexbereich) naturgemäß nur wenige Kupferschichten oder sogar nur eine Kupferschicht führen kann, ist die mögliche Signaldichte über den Flexbereich gering. Und zwar umso geringer, je kleiner der Biegeradius ist, da große Radien wegen der geringeren mechanischen Beanspruchung auch mit relativ dicken Epoxid-Schichten durchgeführt werden können.

Neben der Signaldichte kann auch die elektrische Leitfähigkeit der Kupferieitungen ein Problem sein, beispielsweise, wenn die Leiterplatte in einem Test-Simulationscomputer für elektrische Steuergeräte (ECUs, Electronic Control Units) verbaut ist. Dem Fachmann sind derartige Computersysteme als HILs (Hardware in the Loop) bekannt. Ein HIL dient dem Test und der Optimierung eines Steuergeräts unter reproduzierbaren Bedingungen in einer sicheren, virtuellen Umgebung. Er simuliert die gesamte Umwelt des Steuergerätes wie andere Steuergeräte, Sensoren und die physikalische Umgebung, beliefert das Steuergerät mit Daten und reagiert auf dessen Befehle. Die Leitung starker Ströme kann ein Teil dieser Simulation sein, beispielsweise, um zu testen, wie das Steuergerät auf elektrische Fehler wie Kriechströme oder Kurzschlüsse reagiert. Zur Leitung solcher Ströme können dicke Kupferleitungen vonnöten sein, die über den Flex-Bereich einer nach Stand der Technik gebogenen Semiflex-Platine nicht geführt werden können.

Es besteht deshalb Bedarf nach einem verbesserten Biegeverfahren, das die mechanische Materialbeanspruchung während des Biegevorgangs verringert und so für einen gegebenen Biegeradius einen im Vergleich zum bisherigen Stand der Technik dickeren Flexbereich mit mehr und/oder stärkeren Kupferschichten erlaubt.

Biegevorrichtungen für Semiflex-Leiterplatten nach Stand der Technik funktionieren meist nach dem Prinzip, die Leiterplatte in zwei gegeneinander schwenkbaren Flügeln fest einzuspannen und den Flexbereich, der zwischen zwei nicht verdünnten Starrbereichen angeordnet ist, auf eine Biegelehre aufzulegen. Eine Biegelehre ist dabei einfach eine gekrümmte, einer Kreislinie folgende Fläche, auf der der Flexbereich während des Biegevorgangs aufliegt.

Ein Beispiel für eine solche Vorrichtung zeigt die Druckschrift DE10 2010 001 573 B4. Für die oben geschilderten speziellen Ansprüche im HIL-Bereich erwiesen sich derartige Vorrichtungen in Versuchen als untauglich. Bei Versuchen wurde ein inakzeptabel hoher Anteil der Leiterplatten bei der Biegung zerstört.

Es sind aus dem Stand der Technik auch Biegevorrichtungen bekannt, die keine feste Einspannung der Leiterplatte auf den Flügeln aufweisen. Beispielsweise beschreibt die Druckschrift US 2004/0178539 A1 ein Biegeverfahren für eine Leiterplatte, das vorsieht, den Flexbereich vor der eigentlichen Biegung zunächst in eine Rinne zu stanzen und anschließend die Flügel über die Ränder der Rinne zu biegen, sodass im Ergebnis eine W-förmige Biegung des Flexbereichs entsteht. Um den Stanzvorgang zu ermöglichen, sind die Haltevorrichtungen für die Starrbereiche der Leiterplatte gleitend auf den Flügeln der Biegevorrichtung befestigt.

Jeder Biegevorgang ist für das gebogene Material mit Belastungen verbunden. Aufgrund der von Null verschiedenen Dicke des Materials werden den unterschiedlichen Materialebenen unterschiedliche Biegeradien aufgezwungen. Für flache Strukturen wie eine Semiflex-Leiterplatte bedeutet das, dass die äußeren Schichten der Platte gedehnt und die inneren gestaucht werden, was innerhalb des Materials zu Verwerfungen führt. Dieser Effekt ist unvermeidbar, und er ist umso stärker, je dicker die Platte ist. Deswegen muss der zu biegende Bereich (Flexbereich) einer Semiflex-Leiterplatte vor der Biegung verdünnt werden, z.B. wenigstens von einer Seite ausgefräst werden.

Diese grundsätzliche Belastung durch die Biegung an sich macht aber nur einen Teil der Belastung aus, der eine Semiflex-Leiterplatte während des Biegevorgangs ausgesetzt ist. Ein weiterer Anteil entsteht durch die Handhabung der Leiterplatte während der Biegung. Dieser Anteil ist durch eine geschickte Ausgestaltung der Biegevorrichtung vermeidbar. Im Fall der im Stand der Technik bekannten Biegevorrichtungen sind es zwei Aspekte, die die Leiterplatte besonders belasten.

Zum ersten ist das die Verwendung einer Biegelehre. Sie bewirkt, dass der Flexbereich während des Biegevorgangs nicht gleichmäßig belastet wird, sondern punktuell, genauer entlang der Linie, an der der auf der Biegelehre aufliegende, bereits gebogene Anteil in den ebenen, noch nicht gebogenen Anteil übergeht.

Der zweite Aspekt ist die feste Einspannung der beiden Starrbereiche während der Biegung. Gängige aus dem Stand der Technik bekannte Biegevorrichtungen fixieren zwei gegenüberliegende durch den Flexbereich beabstandete Starrbereiche einer Leiterplatte auf zwei Flügeln, wobei der zwischen den Starrbereichen liegende Flexbereich auf einer Biegelehre aufliegt, und biegen die Leiterplatte dann durch eine gegenläufige Schwenkung der Flügel. Die beiden Flügel mitsamt den Fixierungen beider Starrbereiche bewegen sich dabei auf einer Kreisbahn um die Schwenkachse, während gleichzeitig die Leiterplatte um die Biegelehre "gewickelt" wird.

Diese Art der Biegung entspricht dem Versuch, ein Gummiseil um einen Baumstamm zu wickeln und dabei einen konstanten Abstand zu dem Baumstamm einzuhalten. Das Gummiseil würde dabei in die Länge gezogen und schließlich reißen. Bei Verwendung eines nicht dehnbaren Seils würde die das Seilende haltende Person sich in einer Spiralbahn, die in der Mathematik als Fibonacci-Kurve bekannt ist, auf den Baumstamm zubewegen. Aus dem Stand der Technik bekannte Biegevorrichtungen berücksichtigen diese Bewegung nicht und belasten den Flexbereich deshalb durch Zugspannungen.

Aufgabe der Erfindung ist es, eine Biegevorrichtung und ein Biegeverfahren bereit zu stellen, gemäß denen für Semiflex-Leiterplatten die genannten Hauptursachen für Beschädigungen beim Biegen nicht mehr vorliegen.

Erfindungsgemäß wird diese Aufgabe bei einer vorgenannten gattungsgemäßen Biegevorrichtung bzw. dem gattungsgemäßen Verfahren dadurch gelöst, dass die Position wenigstens einer der beiden Fixiervorrichtungen auf dem jeweiligen Flügel, insbesondere der Abstand von der Schwenkachse, mittels einer Steuervorrichtung in Abhängigkeit des Schwenkwinkels des wenigstens einen verschwenkbaren Flügels verändert wird.

Während des Biegevorgangs kann somit die Position wenigstens einer der Fixiervorrichtungen auf dem zugehörigen Flügel in Abhängigkeit vom Schwenkwinkel des Flügels geändert werden und Zugspannungen auf diese Weise kompensiert werden bzw. deren Auftreten verhindert werden.

Eine einfache Ausführung kann dabei vorsehen, dass nur einer der beiden Flügel um eine Schwenkachse verschwenkt werden kann, wohingegen der andere Flügel ortsfest im Raum verbleibt. Die Erfindung sieht vor, dass beim Verschwenken die Fixiervorrichtung des ortsfesten Flügel oder besonders bevorzugt die des bewegten Flügels in der Position auf dem Flügel geändert wird in Abhängigkeit des Schwenkwinkels des verschwenkten Flügels.

Eine besonders bevorzugte Ausführung sieht hingegen vor, dass beide Flügel um eine bevorzugt gemeinsame Schwenkachse verschwenkt werden und die Fixiervorrichtungen beider Flügel jeweils in der Position auf dem jeweiligen Flügel änderbar ist. Die Änderung der Position erfolgt in Abhängigkeit des Schwenkwinkels des jeweiligen Flügels, also durchaus für beide Fixiervorrichtungen unterschiedlich, sofern die Flügel unabhängig voneinander bewegbar sind.

Ein bevorzugte Ausführung kann hier jedoch vorsehen, dass beide Flügel jeweils nur exakt um denselben Winkel verschwenkt werden können, z.B. dadurch, dass beide Flügel mechanisch aneinander gekoppelt sind.

Unabhängig davon, ob nur ein Flügel oder beide verschwenkbar sind, sieht die Erfindung vor, dass eine in ihrer Position änderbare Fixiervorrichtung in einer Richtung senkrecht zur Schwenkachse verschieblich ist bzw. verfahrensgemäß verschoben wird. Diese Richtung liegt parallel zur Ebene, welche durch den jeweiligen Flügel definiert wird.

Um eine Verschiebbarkeit zu realisieren kann es z.B. vorgesehen sein, dass eine Fixiervorrichtung in einer Führung gleitend oder rollend auf dem Flügel, insbesondere auf dem wenigstens einen schwenkbaren Flügel angebracht ist. Z.B. kann eine Schwalbenschwanzführung oder eine Linearführung mit in Kugelkäfigen umlaufenden Kugeln vorgesehen sein.

Die Erfindung sieht vor, dass die Änderung der Position einer Fixiervorrichtung auf dem Flügel bzw. deren Abstand von der Schwenkachse mittels einer Steuervorrichtung gesteuert wird und in Abhängigkeit des Schwenkwinkels des oder der Flügel erfolgt. Eine solche Steuerung kann z.B. rein mechanisch, aber auch elektrisch erfolgen.

Eine elektrische Steuerung kann mit einer Steuervorrichtung erfolgen, die mittels eines Sensors den Schwenkwinkel oder eine Bewegungsweite des wenigstens einen verschwenkbaren Flügels messtechnisch erfasst und in Abhängigkeit des erfassten Messwertes eine motorische Stellvorrichtung ansteuert, mit welcher die wenigstens eine Fixiervorrichtung, insbesondere die des wenigstens einen verschwenkbaren Flügels bewegbar ist. Hierfür kann in der Steuervorrichtung z.B. ein funktionaler Zusammenhang als Rechenvorschrift oder auch als Zuordnungstabelle zwischen Winkel / Bewegungsweite und einem Ansteuerungswert der Stellvorrichtung vorliegen. Die Stellvorrichtung kann z.B. ein Linearmotor sein.

Bei einer mechanischen Steuerung kann wenigstens eine, insbesondere für jede Fixiervorrichtung wenigstens eine individuelle Führungsvorrichtung vorgesehen sein, welche eine Führungskulisse, insbesondere eine Führungsnut umfasst, in welche ein mit der Fixiervorrichtung verbundenes, durch die Kulisse geführtes Element, insbesondere ein Führungsstift, eingreift.

Die Führungskulisse kann z.B. an einem Gestell der Biegevorrichtung orts- und drehfest angeordnet sein, z.B. um die Schwenkachse definierenden Aufnahmen der Flügelenden herum, sodass durch das Verschwenken eines Flügels das Führungselement der zugeordneten Fixiervorrichtung dieses Flügels durch die Kulisse bewegt wird und hierdurch die Position der Fixiervorrichtung relativ zum Flügel ändert. Ebenso kann durch Verschwenken eines Flügels die wenigstens eine Kulisse bewegt werden, insbesondere rotiert werden, was in gleiche Weise in einer Relativbewegung zwischen Kulisse und geführten Führungselement resultiert und damit in einer Positionsänderung.

Jede der möglichen Ansteuerungsarten kann hier bewirken, dass durch die Steuervorrichtung die Länge des Flexbereichs, insbesondere als Funktion des Schwenkwinkels, zumindest im Wesentlichen konstant gehalten ist und hierdurch Zugspannungen in der Platine vermieden werden. Die Erfindung kann weiterhin vorsehen, dass die Steuerung der Position, insbesondere des Abstandes zur Schwenkachse, für beide Fixiervorrichtungen identisch ist, insbesondere, wenn zwei bewegliche Flügel mechanisch gekoppelt mit identischen Schwenkwinkeln bewegt werden.

Zusätzlich zur Positionsvariablitität der Fixiervorrichtung/en sieht die Erfindung vor, dass der zur Biegung vorgesehene Flexbereich einer eingespannten Leiterplatte sich freischwebend zwischen der ersten Fixiervorrichtung und der zweiten Fixiervorrichtung befindet. So wird auch die punktuelle oder linienförmige Belastung der eingangs beschriebenen Art vermieden.

Die wesentlichen Merkmale der erfindungsgemäßen Biegevorrichtung sind
- 1.: der Verzicht auf eine Biegelehre,
- 2.: beweglich, insbesondere gleitend auf den Flügeln gelagerte Fixiervorrichtungen für die Starrbereiche der Semiflex-Leiterplatte und
- 3.: für jede bewegliche Fixiervorrichtung wenigstens eine Steuervorrichtung, die während des Biegevorgangs die laterale Position der Fixiervorrichtung auf dem jeweiligen Flügel der Biegevorrichtung derart anpasst, dass die Länge d des Flexbereichs während der Biegung konstant bleibt.

Die folgenden Figuren erläutern das Funktionsprinzip der Biegevorrichtung. Es zeigen
Fig. 1 einen Querschnitt einer beispielhaften Semiflex-Leiterplatte,
Fig. 2 die gleiche Semiflex-Leiterplatte während einer Biegung mittels einer Biegelehre,
Fig. 3 eine Totale der erfindungsgemäßen Biegevorrichtung in einer bevorzugten Ausführung, in der die Steuervorrichtung durch eine mechanische Führungsvorrichtung verwirklicht ist,
Fig. 4 eine Detailaufnahme der Vorrichtung aus Fig. 3 mit der Führungsvorrichtung, und
Fig. 5 das Prinzip der Führung der Fixiervorrichtungen durch Führungsnuten anhand einer freigelegten Führungsvorrichtung.

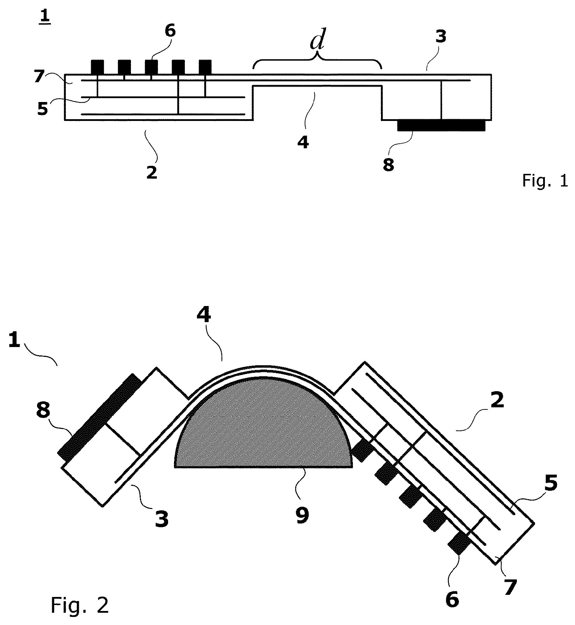

Fig. 1 skizziert zum Verständnis des technischen Hintergrundes der Erfindung eine beispielhafte Semiflex-Leiterplatte 1 im Querschnitt. Sie besteht aus einem Trägersubstrat 7, das meist aus mit Epoxidharz getränkten Glasfasern besteht. Auf dem Substrat sind elektrische oder elektronische Bauteile 6 angeordnet, die durch in das Trägersubstrat 7 eingelassene, schichtförmig angeordnete Kupferleitungen 5 elektrisch miteinander verbunden sind.

Eine Glasfaser-Epoxid-Platte von der Dicke einer typischen Leiterplatte ist nicht dauerhaft biegbar. Für eine Biegung gemäß der Semiflex-Methode wird die Leiterplatte 1 mit einer sich über die gesamte Breite der Leiterplatte 1 erstreckenden Ausfräsung 4 versehen. Die Leiterplatte 1 wird dadurch räumlich unterteilt in einen ersten Starrbereich 2, einen zweiten Starrbereich 3 und einen durch die Ausfräsung gebildeten Flexbereich 4 der Länge d. Innerhalb des Flexbereiches 4 ist die Leiterplatte hinreichend dünn für eine Biegung innerhalb des gewünschten Grades.

Aufgrund der Ausfräsung bietet der Flexbereich 4 nur noch Platz für relativ wenige elektrische Verbindungen zwischen beiden Starrbereichen 2, 3. Nach Stand der Technik ist es nur möglich, eine einzige Kupferleitungsschicht 5 über den Flexbereich 4 zu führen, weil eine Biegung ohne Beschädigung der Leiterplatte 1 ansonsten kaum möglich ist. Für die Signaldichte über den Flexbereich 4 bedeutet das natürlich eine starke Einschränkung, die je nach Anwendung der Leiterplatte 1 problematisch sein kann.

Beispielsweise ist es ein häufiger Anlass zur Biegung einer Leiterplatte, an der Leiterplatte 1 verbaute Steckverbinder 8 für den Anwender zugänglich zu machen. In diesem Fall kann die Leiterplatte 1, wie in Fig. 1 dargestellt, derart ausgestaltet sein, dass alle funktionalen elektronischen Bauteile auf dem ersten Starrbereich 2 angeordnet sind, während der zweite Starrbereich 3 ausschließlich Steckverbinder 8, z.B. für den Anschluss von Peripheriegeräten, Datenleitungen oder Stromkabeln, trägt. Ist die Leiterplatte 1 dann zusätzlich sehr groß und soll deshalb in liegender Ausrichtung im Computersystem verbaut werden, dann muss der zweite Starrbereich 3 um 90° nach oben gebogen werden, um die Steckverbinder an der Rückwand des Computers zugänglich zu machen. Zwangsläufig bedeutet das, dass die gesamte Kommunikation zwischen den elektronischen Komponenten 6 und den über die Steckverbinder 8 mit ihr verbundenen externen Geräten über den Flexbereich 4 geführt werden muss.

Speziell im Anwendungsbereich HIL ergibt sich zudem das Problem, dass auch die mögliche Dicke der über den Flexbereich 4 geführten Kupferlage 11 starken Einschränkungen unterliegt. Das ist nicht von Belang, wenn die Kupferlage 11 nur als Leitung für Daten dient, da deren Übertragung anhand schwacher elektrischer Impulse geschieht. Zu einer HIL-Simulation kann aber auch die Übertragung starker Ströme im Bereich von einigen hundert Ampere gehören, beispielsweise, um die Reaktion eines Steuergerätes auf elektrische Fehler zu prüfen. Ein Flex-Bereich mit einer für derartige Ströme ausgelegten Kupferleitung kann nach Stand der Technik nicht zuverlässig gebogen werden.

Der Einsatz der Semiflex-Technologie in HILs ist aus mehreren Gründen wünschenswert. Alternative Biegetechnologien sind deutlich teurer, und die Verwendung aufgesteckter Kabel zur Verbindung der beiden Starrbereiche würde die Signalqualität verschlechtern. Allerdings ist es nach Stand der Technik nicht möglich, Semiflex-Leiterplatten, die den Anforderungen eines HILs genügen, zuverlässig zu biegen. In der Praxis wird etwa jede zweite Leiterplatte bei der Biegung zerstört.

Fig. 2 skizziert die Biegung des Flexbereichs 4 auf einer Biegelehre 9. Die meisten im Stand der Technik bekannten Vorrichtungen zur Biegung von Semiflex-Leiterplatten arbeiten nach diesem Prinzip. Die Biegelehre 9 ist ein zylindrischer Körper, dessen Mantelfläche einen Halbkreis bildet. Indem der Flexbereich 4 sich im Laufe des Biegevorgangs an die Biegelehre 9 anschmiegt, gibt sie den Krümmungsradius des Flexbereichs 4 nach der Biegung vor.

Eine typische Biegevorrichtung nach Stand der Technik besteht aus zwei schwenkbaren Flügeln, von denen jeder ausgestaltet ist, einen der zwei Starrbereiche 2 und 3 fest einzuspannen. Der Flexbereich 4 wird auf einer Biegelehre aufgelegt und die beiden schwenkbaren Flügel mit den eingespannten Starrbereichen 2 und 3 nach unten geschwenkt.

Diese Methode der Biegung belastet den Flexbereich 4 zusätzlich zu der unvermeidlichen Belastung, die durch Materialverwerfungen durch die Biegung entsteht. Zum einen durch die Kraft, die die Biegevorrichtung auf die Leiterplatte 1 bewirkt. Diese wirkt punktuell entlang der beiden Linien, die die Grenze zwischen dem bereits gebogenen, auf der Biegelehre 9 aufliegenden Anteil des Flexbereichs 4 und dessen noch nicht gebogenen Anteil ausmachen. Zum anderen durch die Zugkraft, die dadurch entsteht, dass der Flexbereich 4 sich bei der Biegung um die Biegelehre 9 wickelt, wie in der Figur erkennbar.

Die Starrbereiche 2 und 3 bewegen sich dadurch natürlicherweise nicht auf einer Kreisbahn, sondern auf einer Fibonacci-Kurve, analog zu dem Ende eines straff gespannten Seils, das um einen Pfahl gewickelt wird. Herkömmliche Biegemaschinen berücksichtigen diesen Umstand nicht. Durch die feste Einspannung zwingen sie die Starrbereiche 2 und 3 auf eine Kreisbahn, deren Abstand zur Biegelehre 9 während der Biegung konstant bleibt, und bewirken dadurch eine Streckung des Flexbereichs 4.

Die Erfindung beschreibt eine Biegevorrichtung für Semiflex-Leiterplatten, die diese zusätzlichen Materialbelastungen während des Biegevorgang weitgehend eliminiert, indem sie auf eine Biegelehre vollständig verzichtet und die Fixiervorrichtungen 20,21, in denen die Starrbereiche jeweils eingespannt werden positionsvariabel, insbesondere auf auf Schienen 22 beweglich lagert und während der Biegung führt.

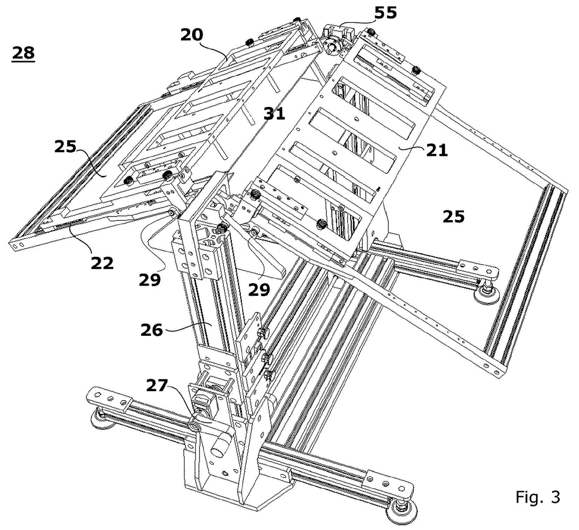

Die Fig. 3 zeigt den Aufbau der erfindungsgemäßen Vorrichtung in einer bevorzugten Ausführung.

Zwei schwenkbare Flügel 25 sind über jeweils zwei Aufhängungen 51, 52 an zwei Standbeinen 26 aufgehängt und in den Aufhängungen 51, 52 um Zapfen 50 drehbar gelagert, die eine Schwenkachse definieren. Zwei Haltearme 29 fixieren die Flügel 25 relativ zu den Standbeinen 26 in einem vorgegebenen, durch einen Regler 27 einstellbaren Schwenkungswinkel. Haltearme 29 und Regler 27 bilden gemeinsam eine Schwenkungsvorrichtung. Bevorzugt ist die Schwenkungsvorrichtung derart ausgestaltet, dass der Schwenkungswinkel jedes schwenkbaren Flügels einen beliebigen Wert von null bis 90° annehmen kann und zu jedem Zeitpunkt für beide schwenkbaren Flügel 25 identisch ist.

Beiden Schwenkflügeln 25 ist je eine Fixiervorrichtung 20, 21 aufgesetzt, die ausgestaltet ist, einen Starrbereich 2, 3 derart zu fixieren, dass der Flexbereich 4 der Leiterplatte 1 über der Lücke 31 zwischen den beiden schwenkbaren Flügeln 25 fixiert ist. Bevorzugt ist auf einem Flügel 25 eine erste Fixiervorrichtung 20 aufgebracht und auf dem anderen Flügel 25 eine zweite Fixiervorrichtung 21, wobei die erste Fixiervorrichtung 20 ausgestaltet ist, einen Starrbereich 2 zu fixieren und die zweite Fixiervorrichtung 21 ausgestaltet ist, den gegenüberliegenden Starrbereich 3 zu fixieren.

Beide Fixiervorrichtungen sind gleitend auf Schienen 22 gelagert, sodass ihre Position auf den schwenkbaren Flügeln 25 bzw. ihre Entfernung von der Lücke 31 bzw. zur Schwenkachse veränderbar ist. Eine Steuervorrichtung 55 steuert ihre Position als Funktion des Schwenkwinkels. Diese Führungsfunktion kann unterschiedlich ausgestaltet sein, beispielsweise in Form einer hier nicht dargestellten elektronischen Steuerung.

Bevorzugt ist sie als mechanische Führungsvorrichtungin Form zweier identischer Führungsnuten 53 ausgestaltet. Jede Führungsnut nimmt einen Führungsstift 57 auf, der jeweils starr mit einer Fixiervorrichtung 20/21 verbunden ist.

Die Breite jeder Führungsnut 53 entspricht der Breite des in ihr eingefassten Führungsstifts 57, sodass jeder Führungsstift nur entlang der durch die Führungsnut 53 beschriebenen Raumkurve bevorzugt spielfrei beweglich ist. Eine Schwenkbewegung eines schwenkbaren Flügels 25 bewirkt eine Verschiebung des zugehörigen Führungsstifts 57 in der Führungsnut 53. Da der Führungsstift dabei einerseits dem Verlauf der Führungsnut folgen muss und andererseits fest mit der Fixiervorrichtung 20, 21 verbunden ist, ist durch den Verlauf der Führungsnut jedem Schwenkwinkel der schwenkbaren Flügel 25 eindeutig eine Position der Fixiervorrichtung 20/21 auf der Schiene 22 zugeordnet.

Erfindungsgemäß ist der Verlauf der Führungsnuten dadurch definiert, dass die Länge des über der Öffnung 31 aufgespannten Flexbereichs 4 für jeden Schwenkungswinkel zumindest im Wesentlichen konstant ist. Unter "im Wesentlichen konstant" wird erfindungsgemäß verstanden, dass die Schwankung der Länge d während eines Biegevorgangs ein für die eingespannte Leiterplatte tragbares Maß nicht übersteigt, insbesondere, dass der Ausschuss an ordnungsgemäß präparierten Leiterplatten durch Biegung mittels der Biegevorrichtung 28 geringer als 10%, 5% oder 2% ist.

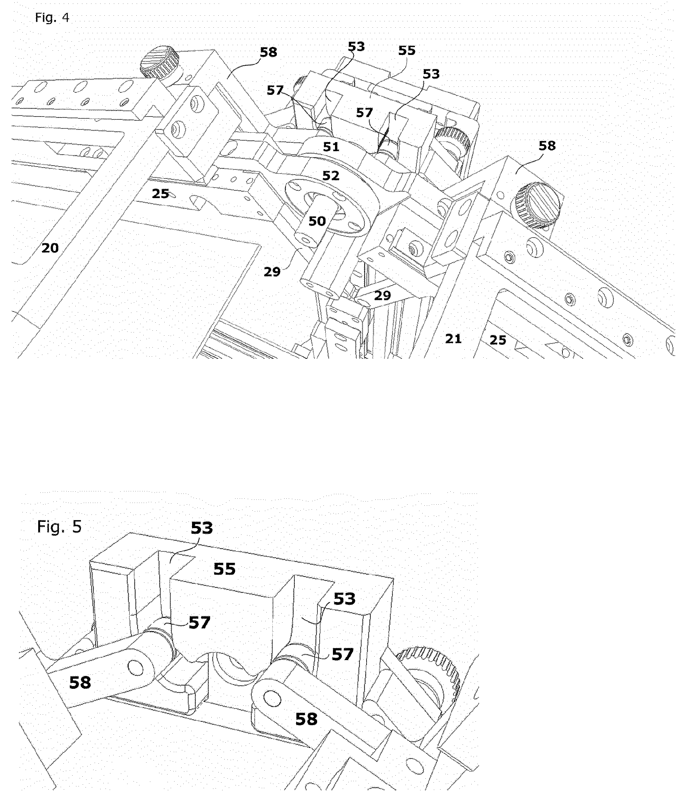

Fig. 4 ist eine Detailaufname aus Fig. 1 und zeigt die Führungsvorrichtung 55. Mittig an der Führungsvorrichtung 55 ist ein Zapfen 50 angebracht, an dem anhand zweier Aufhängungen 51, 52 beide schwenkbaren Flügel 25 aufgehängt sind. Eine identische Aufhängung für beide schwenkbaren Flügel 25 befindet sich auf der gegenüberliegenden Seite. Der Zapfen 50 bildet auf diese Weise gleichzeitig die Schwenkachse für die Schwenkung der schwenkbaren Flügel 25.

Ebenfalls in die Führungsvorrichtung 55 eingelassen sind die Führungsnuten 53. In diese sind Führungsstifte 57 eingelassen, die wiederum starr mit den auf Gleitschienen 22 gelagerten Fixiervorrichtungen 20, 21 verbunden sind. Durch diese Bauart ist die Position beider Fixiervorrichtungen 20, 21 auf den Gleitschienen 22 eine eindeutige Funktion des Schwenkwinkels. Zwei durch einen Regler 27 einstellbare Haltearme 29 halten die schwenkbaren Flügel 25 in einem gewünschten Schwenkwinkel.

Fig. 5 zeigt die freigelegte Führungsvorrichtung 55. Zu erkennen ist, dass die Führungsnuten 53 den Führungsstiften 57 eine Raumkurve vorgeben, der sie im Laufe eines Biegevorgang folgen und damit für jeden Winkel den Fixiervorrichtungen 20, 21 eine Position auf der Gleitschiene 22 vorgeben. Die Raumkurve ist so gewählt, dass die Fixiervorrichtungen 20, 21 mit zunehmendem Schwenkwinkel (wobei ein Schwenkwinkel von 0° bedeutet, dass beide schwenkbaren Flügel 25 eine gemeinsame Ebene aufspannen) immer näher an die die durch die Zapfen 50 definierte Schwenkachse geführt werden, derart, dass die Länge d des Flexbereichs 4 während des gesamten Biegevorgangs im Wesentlichen konstant bleibt.

## Patentansprüche

1. Biegevorrichtung zum Biegen einer Semiflex-Leiterplatte (1) die mindestens einen Flexbereich (4) aufweist, an den an zwei gegenüberliegenden Seiten je ein Starrbereich (2, 3) anschließt, mit
zwei Flügeln (25) und einer auf dem ersten Flügel (25) angebrachten ersten Fixiervorrichtung (20) zur Fixierung eines ersten Starrbereichs (2) der Leiterplatte (1),
und einer auf dem zweiten Flügel (25) angebrachten zweiten Fixiervorrichtung (21) zur Fixierung eines zweiten Starrbereichs (3) der Leiterplatte (1), wobei wenigstens einer der beiden Flügel (25) um eine Schwenkachse verschwenkbar ist und der Abstand wenigstens einer der beiden Fixiervorrichtungen (20, 21) von der Schwenkachse veränderbar ist, **dadurch gekennzeichnet, dass** die Biegevorrichtung eine Steuervorrichtung aufweist, die den Abstand wenigstens einer der beiden Fixiervorrichtungen (20, 21) von der Schwenkachse als Funktion des Schwenkwinkels derart steuert, dass die Länge (d) des Flexbereichs (4) als Funktion des Schwenkwinkels im Wesentlichen konstant gehalten wird.

2. Biegevorrichtung nach Anspruch 1, **dadurch gekennzeichnet, dass** eine in ihrer Position änderbare Fixiervorrichtung (20, 21) in einer Richtung senkrecht zur Schwenkachse verschieblich, insbesondere in einer Führung gleitend oder rollend auf dem Flügel, insbesondere auf dem wenigstens einen schwenkbaren Flügel angebracht ist.

3. Biegevorrichtung nach Anspruch 1 oder 2, **dadurch gekennzeichnet, dass** der Abstand von der Schwenkachse einer, insbesondere jeder Fixiervorrichtung (20,21), mechanisch oder elektrisch gesteuert ist.

4. Biegevorrichtung nach Anspruch 3, **dadurch gekennzeichnet, dass** eine mechanische Steuerung mit einer Führungsvorrichtung (55) erfolgt, welche eine Führungskulisse, insbesondere eine Führungsnut (53) umfasst, in welche ein mit der Fixiervorrichtung (20, 21) verbundenes geführtes Element, insbesondere ein Führungsstift (57) eingreift.

5. Biegevorrichtung nach Anspruch 3, **dadurch gekennzeichnet, dass** eine elektrische Steuerung mit einer Steuervorrichtung erfolgt, die mittels eines Sensors den Schwenkwinkel oder eine Bewegungsweite des wenigstens einen verschwenkbaren Flügels (25) messtechnisch erfasst und in Abhängigkeit des erfassten Messwertes eine motorische Stellvorrichtung ansteuert, mit welcher die wenigstens eine Fixiervorrichtung (20, 21), insbesondere die des wenigstens einen verschwenkbaren Flügels (25), bewegbar ist.

6. Biegevorrichtung nach einem der vorherigen Ansprüche, **dadurch gekennzeichnet, dass** die Steuerung der Position, insbesondere des Abstandes zur Schwenkachse, für beide Fixiervorrichtungen (20, 21) identisch ist.

7. Biegevorrichtung nach einem der vorherigen Ansprüche, **dadurch gekennzeichnet, dass** beide Fixiervorrichtung (20, 21) jeweils auf einem verschwenkbaren Flügel (25) angebracht sind.

8. Biegevorrichtung nach Anspruch 7, **dadurch gekennzeichnet, dass** die Verschwenkung beider schwenkbaren Flügel (25) gegenläufig verläuft und die Schwenkwinkel beider Flügel (25) dabei zu jedem Zeitpunkt den gleichen Betrag aufweisen, insbesondere die schwenkbaren Flügel mechanisch aneinander gekoppelt sind.

9. Biegevorrichtung nach Anspruch 8, **dadurch gekennzeichnet, dass** die beiden schwenkbaren Flügel (25) bei einem jeweiligen Schwenkungswinkel von 0° eine gemeinsame Ebene aufspannen, insbesondere aus dieser Ebene der erste schwenkbare Flügel (25) und der zweite schwenkbare Flügel (25) jeweils um bis zu 90° verschwenkbar sind.

10. Biegevorrichtung nach einem der vorherigen Ansprüche, **dadurch gekennzeichnet, dass** der zur Biegung vorgesehene Flexbereich (4) einer eingespannten Leiterplatte (1) sich freischwebend zwischen der ersten Fixiervorrichtung (20) und der zweiten Fixiervorrichtung (21) befindet.

11. Verfahren zum Biegen einer Semiflex-Leiterplatte (1) mit mindestens einem beidseitig an je einen Starrbereich anschließenden Flexbereich mit einer Biegevorrichtung, insbesondere nach einem der vorherigen Ansprüche, wobei ein erster Starrbereich (2) in einer ersten Fixiervorrichtung (20) eines ersten Flügels (25) der Biegevorrichtung fixiert wird und ein benachbart angeordneter, vom ersten Starrbereich (2) durch einen Flexbereich (4) beabstandeter zweiter Starrbereich (3) in einer zweiten Fixiervorrichtung (21) eines zweiten Flügels (25) der Biegevorrichtung fixiert wird und der Flexbereich (4) durch Verschwenkung wenigstens eines der Flügel (25) gegen den anderen Flügel (25) um eine Schwenkachse gebogen wird, **dadurch gekennzeichnet, dass** der Abstand wenigstens einer Fixiervorrichtung (20, 21) zur Schwenkachse in Abhängigkeit des Schwenkwinkels derart geändert wird, dass während der Biegung die Länge (d) des Flexbereichs (4) als Funktion des Schwenkwinkels zumindest im Wesentlichen konstant gehalten wird.

## Claims

1. A bending device for bending a semiflexible circuit board (1), the circuit board comprising at least one flexible region (4) adjacent to one rigid region (2, 3) on each of two opposite sides thereof,
the bending device comprising two wings (25) and a first fixing device (20) mounted on the first wing (25) for fixing a first rigid region (2) of the circuit board (1),
and a second fixing device (21) mounted on the second wing (25) for fixing a second rigid region (3) of the circuit board (1),
at least one of the two wings (25) being pivotable about a pivot axis and the distance of at least one of the two fixing devices (20, 21) from the pivot axis being changeable,
**characterized in that** the bending device comprises a control device for controlling the distance of at least one of the two fixing devices (20, 21) from the pivot axis as a function of the pivot angle, such that the length (d) of the flexible region (4) is maintained substantially constant as a function of the pivot angle.

2. The bending device according to claim 1, **characterized in that** a fixing device (20, 21) having a changeable position is mounted on the wing displaceably in a direction perpendicular to the pivot axis, particularly sliding or rolling in a guide, particularly on the at least one pivotable wing.

3. The bending device according to claim 1 or 2, **characterized in that** the distance from the pivot axis of a fixing device (20, 21), particularly every fixing device, is controlled mechanically or electrically.

4. The bending device according to claim 3, **characterized in that** a mechanical control takes place by means of a guide device (55) comprising a guide track, particularly a guide slot (53), in which a guided element connected to the fixing device (20, 21), particularly a guide pin (57), engages.

5. The bending device according to claim 3, **characterized in that** an electrical control takes place by means of a control device capturing the pivot angle or a displacement distance of the at least one pivotable wing (25) by means of a measuring sensor and actuating a motorized actuator as a function of the captured measured value, by means of which the at least one fixing device ((20, 21), particularly the at least one pivotable wing (25), can be displaced.

6. The bending device according to any one of the preceding claims, **characterized in that** the controlling of the position, particularly the distance from the pivot axis, is identical for the two fixing devices (20, 21).

7. The bending device according to any one of the preceding claims, **characterized in that** the two fixing devices (20, 21) are mounted on one pivotable wing (25) each.

8. The bending device according to claim 7, **characterized in that** the pivoting of the two pivotable wings (25) runs opposite each other and that the pivot angles of the two wings (25) thereby comprise the same value at all times, particularly that the pivotable wings are mechanically coupled to each other.

9. The bending device according to claim 8, **characterized in that** the two pivotable wings (25) extend in a common plane at a pivot angle of 0° each, particularly that the first pivotable wing (25) and the second pivotable wing (25) are each pivotable by up to 90° out of said plane.

10. The bending device according to any one of the preceding claims, **characterized in that** the flexible region (4) of a clamped circuit board (1) provided for bending is free-floating between the first fixing device (20) and the second fixing device (21).

11. A method for bending a semiflexible circuit board (1) having at least one flexible region adjacent on two sides to one rigid region each by means of a bending device, particularly according to any one of the preceding claims,
a first rigid region (2) being fixed in a first fixing device (20) of a first wing (25) of the bending device and an adjacent second rigid region (3) spaced apart from the first rigid region by a flexible region (4) being fixed in a second fixing device (21) of a second wing (25) of the bending device, and the flexible region being bent by pivoting at least one of the wings (25) relative to the other wing (25) about a pivot axis,
**characterized in that** the distance of at least one fixing device (20, 21) from the pivot axis is changed as a function of the pivot angle such that the length (d) of the flexible region (4) is kept at least substantially constant as a function of the pivot angle during the bending.

## Revendications

1. Dispositif de cintrage pour cintrer une plaquette de circuit imprimé Semiflex (1) présentant au moins une zone flexible (4), à laquelle s'enchaîne respectivement, sur deux côtés opposés, une zone rigide (2, 3), avec
deux ailes (25) et un dispositif de fixation (20) agencé sur la première aile (25) pour la fixation d'une première zone rigide (2) de la plaquette de circuit imprimé (1),
et un second dispositif de fixation (21) agencé sur la seconde aile (25) pour la fixation d'une seconde zone rigide (3) de la plaquette de circuit imprimé (1), sachant que l'une au moins des deux ailes (25) peut être pivotée autour d'un axe de pivotement et la distance de l'un au moins des deux dispositifs de fixation (20, 21) par rapport à l'axe de pivotement est variable, **caractérisé en ce que** le dispositif de cintrage comporte un dispositif de commande qui commande la distance d'au moins l'un des deux dispositifs de fixation (20, 21) par rapport à l'axe de pivotement en tant que fonction de l'angle de pivotement de sorte que la longueur (d) de la zone flexible (4) soit maintenue à une valeur essentiellement constante en tant que fonction de l'angle de pivotement.

2. Dispositif de cintrage selon la revendication 1, **caractérisé en ce qu**'un dispositif de fixation (20, 21) variable en position est agencé dans une direction perpendiculaire à l'axe de pivotement de manière translatable, en particulier coulissante dans un guidage ou roulante sur l'aile, en particulier agencé sur l'au moins une aile pivotante.

3. Dispositif de cintrage selon la revendication 1 ou 2, **caractérisé en ce que** la distance par rapport l'axe de pivotement d'un, en particulier de chaque dispositif de fixation (20, 21) est commandée mécaniquement ou électriquement.

4. Dispositif de cintrage selon la revendication 3, **caractérisé en ce qu**'une commande mécanique est effectuée avec un dispositif de guidage (55), lequel comporte une coulisse de guidage, en particulier une rainure de guidage (53), dans laquelle entre en prise un élément guidé relié, en particulier un doigt de guidage (57).

5. Dispositif de cintrage selon la revendication 3, **caractérisé en ce qu**'une commande électrique est effectuée avec un dispositif de commande, qui, à l'aide d'un capteur, saisit par mesure l'angle de pivotement ou une amplitude de mouvement de l'au moins une aile (25) pivotante et commande un dispositif de manoeuvre à moteur en fonction de la valeur de mesure saisie, avec lequel l'au moins un dispositif de fixation (20, 21), en particulier celui de l'au moins une aile pivotante (25), peut être déplacé.

6. Dispositif de cintrage selon l'une des revendications précédentes, **caractérisé en ce que** la commande de la position, en particulier de la distance par rapport à l'axe de pivotement, est identique pour les deux dispositifs de fixation (20, 21).

7. Dispositif de cintrage selon l'une des revendications précédentes, **caractérisé en ce que** les deux dispositifs de fixation (20, 21) sont agencés respectivement sur une aile pivotante (25).

8. Dispositif de cintrage selon la revendication 7, **caractérisé en ce que** le pivotement des deux ailes pivotantes (25) s'effectue en contre-sens l'un par rapport l'autre et les angles de pivotement des deux ailes (25) présentent à tout moment la même valeur, en particulier les ailes pivotantes sont couplées mécaniquement l'une à l'autre.

9. Dispositif de cintrage selon la revendication 8, **caractérisé en ce que** les deux ailes pivotantes (25), à un angle de pivotement respectif de 0°, tendent un plan commun, en particulier la première aile pivotante (25) et la seconde aile pivotante (25) sont respectivement pivotantes de jusqu'à 90° à partir de ce plan.

10. Dispositif de cintrage selon l'une des revendications précédentes, **caractérisé en ce que** la zone flexible (4) d'une plaquette de circuit imprimé (1) bridée, qui est prévue pour le cintrage, est située en suspension libre entre le premier dispositif de fixation (20) et le second dispositif de fixation (21).

11. Procédé pour le cintrage d'une plaquette de circuit imprimé Semiflex (1) avec au moins une zone flexible s'enchaînant sur les deux côtés à respectivement une zone rigide à l'aide d'un dispositif de cintrage, en particulier selon l'une des revendications précédentes, sachant qu'une première zone rigide (2) est fixée dans un premier dispositif de fixation (20) d'une première aile (25) du dispositif de cintrage et une seconde zone rigide (3) voisine distancée de la première zone rigide (2) par une zone flexible (4) est fixée dans un second dispositif de fixation (21) d'une seconde aile (25) du dispositif de cintrage et la zone flexible (4) est cintrée par pivotement d'au moins l'une des ailes (25) vers l'autre aile (25) autour d'un axe de pivotement, **caractérisé en ce que** la distance d'au moins un dispositif de fixation (20, 21) par rapport à l'axe de pivotement est variée en fonction de l'angle de pivotement de sorte que, lors du cintrage, la longueur *(d)* de la zone flexible (4) soit maintenue à une valeur au moins essentiellement constante en tant que fonction de l'angle de pivotement.
